# EUROPEAN PATENT SPECIFICATION

(11) **EP 2 455 770 B1**
(45) Date of publication and mention of the grant of the patent: **20.04.2016**
(21) Application number: 10014905.3
(22) Date of filing: 23.11.2010
(51) Int. Cl.: G01R 31/01, G01R 31/28

(54) **Method of operating a test-in-strip handler**
Verfahren für den Betrieb eines Test-in-Strip-Handlers
Procédé de fonctionnement d'un manipulateur de bande de test

(43) Date of publication of application: 23.05.2012
(73) Proprietor: Rasco GmbH, 83059 Kolbermoor (DE)
(72) Inventor: Waldauf, Alexander, 6306 Söll (AT); Roider, Peter, 93092 Barbing (DE); Hittmann, Rainer, 93092 Barbing (DE)
(74) Representative: Grünecker Patent- und Rechtsanwälte PartG mbB

(56) References cited:
- WO-A1-2010/021038
- WO-A1-2010/109678
- US-A1- 2004 077 200

## Description

### Field of the Invention

The present invention relates to a method of operating a strip handler, in particular test-in-strip handler, having a loader unit, a processing unit, in particular a testing unit or a marking unit, and an unloader unit. The present invention further relates to a strip handler, in particular test-in-strip handler, having a loader unit, a processing unit, in particular a testing unit or a marking unit, and an unloader unit.

### Prior Art

For testing the quality of integrated circuits (ICs) so called handlers are operated. The handler places the ICs in contact with an automatic test system to verify their function. Based on the test results, the ICs are sorted by the handler to make them available for packaging or other applications.

A particular type of handler is the so called Test-In-Strip Handler which is configured to simultaneously test a complete strip with a plurality of ICs. A loader unit of the test-in-strip handler contains one stack of IC strips. From this stack, individual IC strips are fed to a testing unit comprising a plunger / plunger head that positions the IC strip relative to the contact pins of a contactor. Testing is performed by moving the IC strip towards the contactor, such that the contact pins of the contactor contact corresponding leads of the ICs on the IC strip. Then a test procedure is started in order to test the ICs for correct operation. After testing, the IC strip is unloaded from the plunger to an unloader unit and strips that did pass the test on the one hand and strips that did not pass the test on the other hand are placed in corresponding stacks, in order to have sorted stacks in the unloader unit. Further, malfunctioning ICs may be marked with an integrated laser marker.

Moreover, it may happen that the test could not be performed, for example due to deteriorated contact of the contact pins or another temporary malfunctioning of the testing unit. These strips need to be tested again after the reason for the malfunctioning has been eliminated.

Although a loader unit may have compartments for further stacks available, only exactly one compartment has been used in the prior art, since according to a "golden rule" strips from different production lots must not be mixed and should be kept separate by any means. In particular, for convenience the same unit that operates as the unloader unit was generally used as the loader unit as well. However, at a time only one compartment of this unit was filled with strips when operated as a loader unit. The other compartments were left empty, in order to avoid any mixing of strips from different production lots.

This method of the prior art has the disadvantage that the test-in-strip handler has a large fraction of down time (up to 30%), since the loader unit has to be filled up when the stack in the one compartment has run empty.

Relevant prior art is described e.g. in the 2^{nd} embodiment of US 2004/077200 A1 (ISHIKAWA TAKAJI [JP] ET AL) 22 April 2004 (2004-04-22).

### Description of the Invention

The problem underlying the present invention in view of the prior art is to provide a method of operating a strip handler, in particular a test-in-strip handler, such that the above-mentioned problems are overcome. In particular, it is an object of the present invention to reduce the down time of a test-in-strip handler.

The above-mentioned problem is solved by the method according to claim 1.

According to an aspect of the invention, the inventive method refers to a method of operating a strip handler, in particular a Test-In-Strip Handler having a loader unit, a processing unit, in particular a testing unit or a marking unit, and an unloader unit, the loader unit comprising a first number N1 of compartments and each compartment of the loader unit being configured to receive a stack of strips, the unloader unit comprising a second number N2 of compartments and each compartment of the unloader unit being configured to receive a stack of strips, the method comprising the steps:
(a) placing a number N of stacks of strips in N respective compartments of the loader unit;
(b) loading a strip from the loader unit to the processing unit for processing the strip;
(c) unloading the strip from the processing unit; and
(d) stacking the strip to one of a number N+M of compartments of the unloader unit;
wherein N ≥ 2, M ≥ 1, N ≤ N1 and (N + M) ≤ N2;
and wherein each strip has a strip-ID that comprises information for identifying the particular strip, in particular information for identifying a production lot for that strip, the strip-ID being read by an ID-reader of the strip handler.

According to the invention more than one, namely at least two compartments (N ≥ 2), contain a respective stack of strips of ICs. However, not all of the available number of N1 compartments in the loader unit need to be used (N ≤ N1), but may be used. The number (N + M) of compartments used in the unloader unit is at least one more (M ≥ 1) than the number N of compartments used in the loader unit, such that strips for which the processing in the processing unit has failed are stacked to this at least one additional stack, whereas strips that have passed the processing, in particular the testing or marking, are stacked to the other N compartments. This has the advantage that the fractional downtime of the handler for changing the loader unit and/or filling up the loader unit is considerably reduced, since the runtime is increased. The processing in the processing unit may refer to an electrical testing of the strip regarding the functioning of the ICs of the strip or may refer to marking of the strips, such as laser marking. However, other processing operations related to the strips may be performed.

According to another aspect of the invention, the inventive method refers to a method of operating a strip handler, in particular a Test-In-Strip Handler having a loader unit, a processing unit, in particular a testing unit or a marking unit, and an unloader unit, the loader unit comprising a first number N1 of compartments and each compartment of the loader unit being configured to receive a stack of strips, the unloader unit comprising a second number N2 of compartments and each compartment of the unloader unit being configured to receive a stack of strips, the method comprising the steps:
(a) placing a number N of stacks of strips in N respective compartments of the loader unit;
(b) loading a strip from the loader unit to the processing unit for processing the strip;
(c) unloading the strip from the processing unit; and
(d) stacking the strip to one of a number N+M of compartments of the unloader unit;
wherein N = 1, M ≥ 1, N ≤ N1 and (N + M) ≤ N2;
and wherein each strip has a strip-ID that comprises information for identifying the particular strip, in particular information for identifying a production lot for that strip, the strip-ID being read by an ID-reader of the strip handler.

According to this aspect of the invention, exactly one compartment of the loader unit is filled with a stack of strips. Similar to the previous aspect, the number (N + M) of compartments used in the unloader unit is at least one more (M ≥ 1) than the number N of compartments used in the loader unit, such that strips for which the processing in the processing unit has failed are stacked to this at least one additional stack, whereas strips that have successfully been processed are stacked to the other N compartments. This has the advantage that the fractional downtime of the handler for changing the loader unit and/or filling up the loader unit is considerably reduced, since the runtime is increased. However, all strips in the one compartment of the loader unit should preferably be from one production lot, or the strips should preferably have a strip-ID as further detailed below.

The following developments refer to both aspects of the invention.

According to a development of the invention, the method may comprise repeating steps (b) - (d), in particular repeating steps (b) - (d) until the loader unit is empty and then repeating step (a). Repeating the corresponding step until the loader unit is emptied from strips further increases the runtime of the handler and, hence, reduces its fractional downtime.

According to a further development of the invention, each of the N stacks in the loader unit may comprise only strips of one production lot, in particular wherein each stack comprises strips from a different respective production lot or wherein all of the N stacks comprise strips from the same production lot. This has the advantage that strips from different production lots are kept separate in the loader unit.

According to another development, the additional number M of used compartments in the unloader unit (when compared to the number N of used compartments in the loader unit) may be one (M = 1), and each of N stacks in the unloader unit comprises only strips of one production lot having passed the processing and one stack in the unloader unit comprises only strips for which processing has failed, in particular, wherein each of the N stacks in the unloader unit comprises only strips of a different respective production lot. This has the advantage that the strips that have passed the processing are sorted in the unloader unit according to the production lot the particular strip originates from. Further, strips that failed the processing are stacked in one compartment of the unloader unit irrespective of the production lot.

According to another development, M may be 2 and each of N stacks in the unloader unit comprises only strips of one production lot having passed the processing and one stack in the unloader unit comprises only strips for which processing has failed due to a malfunction of the processed, in particular tested, strip and another stack in the unloader unit comprises only strips for which processing has failed due to a malfunction of the procesing unit, preferably, wherein each of the N stacks in the unloader unit comprises only strips of a different respective production lot. This has the advantage that the stack of strips for which processing has failed due to a malfunction of the processing unit, for example due to a temporary disturbance or an interference in the test circuit in case of a testing unit, can easily be placed back to the loader unit to run through the processing again.

According to a further development, the additional number M of used compartments in the unloader unit may be the same as the number N of used compartments in the loader unit, namely M=N and the stacking in step (d) is performed such that each of N stacks in the unloader unit comprises only strips of one production lot having passed the processing and N stacks in the unloader unit comprises only strips of one production lot having failed the processing, in particular, wherein each of the 2N stacks in the unloader unit comprises only strips of a different respective production lot. This has the advantage that also strips having failed the processing can be sorted according to the production lot.

According to the invention, each strip may have a strip-ID that comprises information for identifying said strip, the strip-ID being read by an ID-reader of the Strip Handler. In particular the strip-ID may include information about a production lot for that strip. Such strip-ID may for example be a marking on the strip or a label, in particular in the form of a bar code. The strip-ID includes information unambiguously identifying the particular strip and may contain information on the production lot to which the particular strip belongs, and may contain further information of the specific strip, such as a number of ICs included or the particular type of ICs included.

According to a further development in combination with the last development, the stacks placed in the compartments of the loader unit may comprise strips from different production lots. As the strips can be identified regarding the production lot by reading the information contained in the strip-ID, the strips my be placed into the loader unit without sorting them into stacks of only one respective production lot, the handling of the strips in the loader unit is simplified.

According to another development, the strips may be stacked to a particular one of the compartments of the unloader unit based on the information read. This has the advantage that each stack of the processed strips in the unloader unit includes only strips of one production lot, when the information read is information on the production lot, which simplifies the subsequent handling of the strips. Alternatively or additionally the strips may be sorted regarding other criteria.

According to a further development N may be equal to M, or M may be equal to 1. This has the advantage that for N=M, the strips may be sorted in N stacks according to their production lot in the loader unit, and after performing the processing, the strips may be sorted in 2N stacks according to their production lot and further according to having passed or having failed the processing for each production lot. The case of M=1 may for example be relevant if the strips having failed the processing are discarded. Further, the strips may include a strip-ID such that they may be resorted, for example before or after a reprocessing is or has been performed.

The invention also provides a strip handler, in particular a test-in-strip handler according to claim 10.

The strip handler according to the invention for performing a method according to the invention comprises:
a loader unit;
a processing unit; and
an unloader unit;
wherein the loader unit comprises a first number N1 ≥ 2 of compartments and each compartment of the loader unit is configured to receive a stack of strips, the unloader unit comprises a second number N2 ≥ (N1 + 1) of compartments and each compartment of the unloader unit is configured to receive a stack of strips.

In the strip handler according to the invention, the number of compartments in the unloader unit is at least by one larger than the number of compartments in the loader unit. Accordingly, there is at least one extra compartment in the unloader unit for strips for which the processing has failed.

According to a development of the strip handler according to the invention, optionally one of the following relations may be fulfilled: N2 = (N1 + 1), N2 = (N1 + 2) or N2 = 2·N1. The advantages of such configurations with respect to sorting the strips in the unloader unit after processing have already been discussed in relation to the method according to the invention and its developments.

According to another development, the strip handler may further comprise one or more additional loader units and/or one or more additional unloader units. In particular, one loader unit with N1 compartments may be used on the loader side of the strip handler and two similar units may be used on the unloader side of the strip handler, such that 2N1 compartments are available on the unloader side.

According to another development, the strip handler may further comprise an ID-reader for reading an ID of a strip. This has the advantage that identification markings on the strips can be read, such that strip specific processing may be performed and/or strips may be identified regarding their production lot and/or sorted according to their production lot.

According to a further development, the loader unit may comprise K subunits and the unloader unit may comprise L of said subunits, wherein L ≥ 2 for K=1 and L ≥ K for K > 1. In this development either the loader unit or the unloader unit or both may be modular, in particular identical subunits can be used to configure both, the loader and the unloader unit form these identical subunits. The configuration can thus be adapted to the specific needs with only one type of module / subunit.

Further features and advantages of the present invention will be described in the following with reference to the figures, which illustrate only examples of embodiments of the present invention. The illustrated and described features may be suitably combined with each other.

### Brief Description of the Drawings

- Fig. 1: illustrates an embodiment of the method according to the invention.
- Fig. 2: illustrates an embodiment of the method according to the invention applied to a test-in-strip-handler according to the prior art.
- Fig. 3: illustrates an embodiment of the test-in-strip-handler according to the invention.
- Fig. 4: illustrates another embodiment of the test-in-strip handler according to the invention.

### Description of the Embodiments

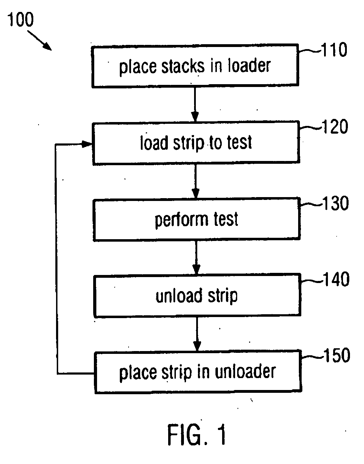

Figure 1 shows an embodiment of the inventive method 100. In this embodiment of the method according to the invention, the first step 110 is to place a particular number N of stacks of strips with ICs to be tested into respective compartments of a loader unit. For example, the loader unit may have N1=4 compartments available and the number N of compartments wherein a stack of strips is placed is larger than 1, it may be 2, for example. In the second step 120, one of the strips is loaded from the loader unit to the testing unit for performing the testing step 130 on the strip.

After the test procedure has ended, the next step 140 is to remove/unload the strip from the testing unit, and as the last step 150, the strip is placed/stacked in one of the compartments of the unloader unit. The placement of the strip onto a particular stack in the unloader unit depends on the test result. If the strip has passed the test or the tests, it is stacked in a compartment including only strips that passed the test. If the testing of the strip failed (because the strip contains at least one IC that did not operate as desired or because the testing unit did not operate properly) it is placed on a stack of the unloader unit containing only strips where the test failed. The method then returns to loading the next strip until the loader unit is emptied, whence it has to be filled up again.

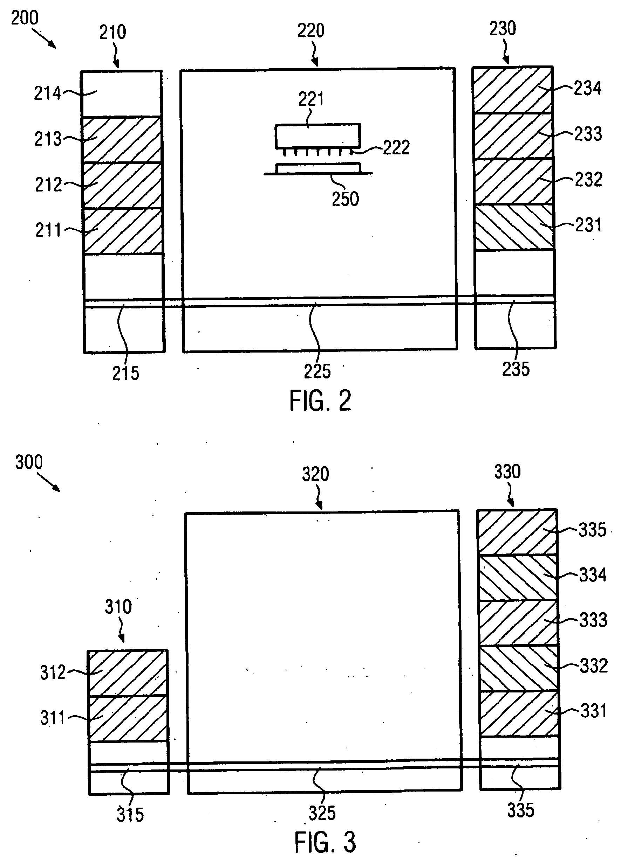

Figure 2 shows an embodiment of the method according to the invention applied to a test-in-strip-handler 200 according to the prior art. In this embodiment of the invention, the test-in-strip-handler 200 includes a loader unit 210 that has N1=4 compartments 211-214. Only 3 compartments 211-213 contain a stack of strips to be tested. For example, although each stack contains only strips from one and the same production lot, the strips in the different compartment may be from different production lots.

The strips may have an identification tag that identifies the strip, for example by using a number, such that this information may be used to identify the production lot the strip belongs to, which an optional reading device in the testing unit may read, and in this case the strips may also be placed unsorted into the loader unit, since as sorting can be performed later. The loader unit further comprises a transport device 215, for example a transport belt 215. Furthermore, the loader unit includes a pick-and-place device that picks a strip 250 of ICs and places it on the belt 215 where it can be transported to an exit of the loader unit 210.

The strip is transported to an entry point and on a transport belt 225 of a testing unit 220. From this transport device 225 of the testing unit a further pick-and-place mechanism positions the strip 250 to a contactor 221 having contact pins 222 of the testing device, where tests regarding the proper function of the ICs of the strip are performed. After testing, the strip is placed back to the belt 225 and is conveyed to an exit point of the testing unit 220.

The strip then reaches an entry of an unloader unit 230 and is further transported to a belt 235 of the unloader unit 230. The unloader unit is 230 similar in design as the loader unit 210, in particular, it has the same number N2=N1=4 of compartments for stacking IC-strips. In the unloader unit 230 the strip 250 is picked-up by a device similar to the pick-and-place device in the loader unit 210 and places the strip onto one of the stacks in the compartments 231-234 of the unloader unit 230. The assignment of the strip 250 to a particular compartment 231-234 is preferably done such that for example the first compartment 231 over which the pick-and-place device carries the strip is used for strips where the test failed This has the advantage that strips accidentally falling off the pick-and-place device during placement do not spoil the stack(s) of strips which passed the test. The other compartments 232-234 are used such that the assignment corresponds to the arrangement of the stacks in the compartments 211-213, respectively, in the loader unit 210, hence, keeping the sorting of the respective production lots, for example.

Figure 3 illustrates an embodiment of a test-in-strip-handler 300 according to the invention. When compared to the handle of Figure 2, similar parts have been given a similar reference number, only increased by 100, such that 2nn becomes 3nn. According to the invention, the number N2 of compartments in the unloader unit 330 is at least by one larger than the number N1 of compartments in the loader unit 310. In the particular example, the loader unit 310 comprises N1=2 compartments 311-313, whereas the unloader unit 330 includes N2=5 compartments.

The operation of the handler 300 is similar to the operation as described above. The sorting in the unloader unit 330 may be performed such that the first compartment 331 contains defective IC-strips, compartment 332 contains strips of a first production lot where an error of the testing unit 320 occurred during testing, compartment 333 contains strips of a second production lot where an error of the testing unit 320 occurred during testing, compartment 334 contains strips of the first production lot that have passed the test, and compartment 335 contains strips of the second production lot that have passed the test. In this way it is easy to keep the strips sorted by their production lot and to retest the strips where an error of the testing unit 320 occurred during testing. Additionally or alternatively the strips that did not pass the test and include one ore more malfunctioning ICs may be sorted according to their production lot.

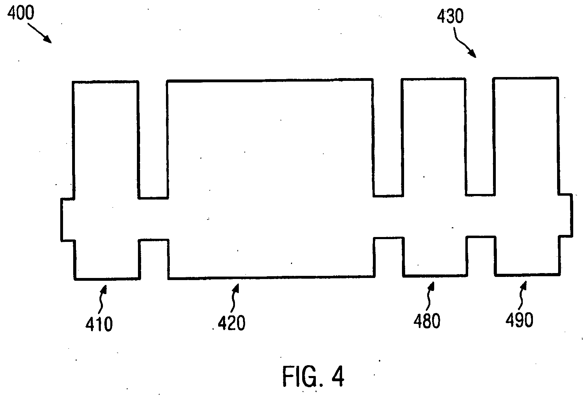

Figure 4 illustrates a test-in-strip handler 400 according to the invention having a modular unloader unit 430, comprising two identical subunits 480, 490. An identical subunit is also used as the loader unit 410. The two subunits 480 and 490 are connected to each other, so that strips can pass through one subunit 480 and enter the other subunit 490.

Further embodiments of the invention have a marking unit instead of or additional to the testing unit as the processing unit.

## Claims

1. Method of operating a strip handler, in particular a Test-In-Strip Handler having a loader unit, a processing unit, in particular a testing unit or a marking unit, and an unloader unit, the loader unit comprising a first number N1 of compartments and each compartment of the loader unit being configured to receive a stack of strips, the unloader unit comprising a second number N2 of compartments and each compartment of the unloader unit being configured to receive a stack of strips, the method comprising the steps:
(a) placing a number N of stacks of strips in N respective compartments of the loader unit;
(b) loading a strip from the loader unit to the processing unit for processing the strip;
(c) unloading the strip from the processing unit; and
(d) stacking the strip to one of a number N+M of compartments of the unloader unit;
wherein N ≥ 2, M ≥ 1, N ≤ N1 and (N + M) ≤ N2;
wherein each strip has a strip-ID that comprises information for identifying the particular strip, in particular information for identifying a production lot for that strip, the strip-ID being read by an ID-reader of the strip handler.

2. Method according to claim 1, further comprising repeating steps (b) - (d), in particular repeating steps (b) - (d) until the loader unit is empty and then repeating step (a).

3. Method according to claim 1 or 2, wherein each of the N stacks in the loader unit comprises only strips of one production lot, in particular wherein each stack comprises strips from a different respective production lot or wherein all of the N stacks comprise strips from the same production lot.

4. Method according to one of claims 1 to 3, wherein M=1 and each of N stacks in the unloader unit comprises only strips of one production lot having passed the processing and one stack in the unloader unit comprises only strips for which processing has failed, in particular, wherein each of the N stacks in the unloader unit comprises only strips of a different respective production lot.

5. Method according to one of claims 1 to 3, wherein M=2 and each of N stacks in the unloader unit comprises only strips of one production lot having passed the processing and one stack in the unloader unit comprises only strips for which processing has failed due to a malfunction of the processed strip and another stack in the unloader unit comprises only strips for which processing has failed due to a malfunction of the processing unit, preferably, wherein each of the N stacks in the unloader unit comprises only strips of a different respective production lot.

6. Method according to one of claims 1 to 3, wherein M=N and the stacking in step (d) is performed such that each of N stacks in the unloader unit comprises only strips of one production lot having passed the processing and N stacks in the unloader unit comprises only strips of one production lot having failed the processing, in particular, wherein each of the 2N stacks in the unloader unit comprises only strips of a different respective production lot.

7. Method according to claim 1, wherein the stacks placed in the compartments of the loader unit comprise strips from different production lots.

8. Method according to any one of claims 1 to 7, wherein the strips are stacked to a particular one of the compartments of the unloader unit based on the information read.

9. Method according to one of claims 1 to 8, wherein N=M or M=1.

10. Strip handler, in particular a Test-In-Strip Handler, for performing a method according to one of claims 1 to 9, comprising:
a loader unit;
a processing unit; and
an unloader unit;
wherein the loader unit comprises a first number N1 ≥ 2 of compartments and each compartment of the loader unit is configured to receive a stack of strips, the unloader unit comprising a second number N2 ≥ (N1 + 1) of compartments and each compartment of the unloader unit is configured to receive a stack of strips;
the strip handler further comprising an ID-reader for reading an ID of a strip.

11. Strip Handler according to claim 10, wherein N2 = (N1 + 1), N2 = (N1 + 2) or N2 = 2·N1.

12. Strip Handler according to claim 10 or 11, further comprising one or more additional loader units and/or one or more additional unloader units.

13. Strip Handler according to one of claims 10 to 12, wherein the loader unit comprises K subunits and the unloader unit comprises L of said subunits, and wherein L ≥ 2 for K=1 and L ≥ K for K > 1.

## Patentansprüche

1. Verfahren zum Betreiben einer Bauteilstreifen-Handhabungseinheit, insbesondere einer Prüfung-im-Streifen-Handhabungseinheit, mit einer Ladeeinheit, einer Verarbeitungseinheit, insbesondere einer Prüfeinheit oder einer Markiereinheit, und einer Entladeeinheit, wobei die Ladeeinheit eine erste Anzahl N1 an Fächern aufweist und wobei jedes Fach der Ladeeinheit ausgebildet ist, einen Stapel aus Streifen aufzunehmen, wobei die Entladeeinheit eine zweite Anzahl N2 an Fächern aufweist, und wobei jedes Fach der Entladeeinheit ausgebildet ist, einen Stapel aus Streifen aufzunehmen, wobei das Verfahren die Schritte umfasst:
(a) Platzieren einer Anzahl N an Stapeln aus Streifen in N jeweiligen Fächern der Ladeeinheit;
(b) Transportieren eines Streifens von der Ladeeinheit in die Verarbeitungseinheit zur Verarbeitung des Streifens;
(c) Ausladen des Streifens aus der Verarbeitungseinheit; und
(d) Stapeln des Streifens in einem Fach aus einer Anzahl N + M an Fächern der Entladeeinheit;
wobei N ≥ 2, N ≥ 1, N ≤ N1 und (N + M) ≤ N2 gilt;
wobei jeder Streifen eine Streifenkennung aufweist, die Information zur Kennzeichnung des speziellen Streifens, insbesondere Information zur Kennzeichnung eines Herstellungsloses für diesen Streifen umfasst, wobei die Streifenkennung von einer Kennung-Leseeinheit der Bauteilstreifen-Handhabungseinheit lesbar ist.

2. Verfahren nach Anspruch 1, das ferner umfasst: Wiederholen der Schritte (b) - (d), insbesondere Wiederholen der Schritte (b) - (d), bis die Ladeeinheit leer ist, und dann Wiederholen des Schritts (a).

3. Verfahren nach Anspruch 1 oder 2, wobei jeder der N Stapel in der Ladeeinheit nur Streifen eines einzelnen Herstellungsloses umfasst, wobei insbesondere jeder Stapel Streifen aus einem anderen jeweiligen Herstellungslos aufweist, oder wobei alle N Stapel Streifen aus dem gleichen Herstellungslos aufweisen.

4. Verfahren nach einem der Ansprüche 1 bis 3, wobei M = 1 und jeder von N Stapeln in der Entladeeinheit nur Streifen eines einzelnen Herstellungsloses aufweist, die die Verarbeitung erfolgreich durchlaufen haben, und ein einzelner Stapel in der Entladeeinheit nur Streifen aufweist, für die die Verarbeitung fehlgeschlagen hat, wobei insbesondere jeder der N Stapel in der Entladeeinheit nur Streifen eines anderen jeweiligen Herstellungsloses aufweist.

5. Verfahren nach einem der Ansprüche 1 bis 3, wobei M = 2 und jeder von N Stapeln in der Entladeeinheit nur Streifen eines einzelnen Herstellungsloses aufweist, die die Verarbeitung erfolgreich durchlaufen haben, und ein einzelner Stapel in der Entladeeinheit nur Streifen aufweist, für die die Verarbeitung fehlgeschlagen hat aufgrund einer Fehlfunktion des verarbeiteten Streifens, und ein weiterer Stapel in der Entladeeinheit nur Streifen aufweist, für die die Verarbeitung aufgrund einer Fehlfunktion der Verarbeitungseinheit fehlgeschlagen hat, wobei vorzugsweise jeder der N Stapel in der Entladeeinheit nur Streifen eines anderen jeweiligen Herstellungsloses aufweist.

6. Verfahren nach einem der Ansprüche 1 bis 3, wobei M = N ist und wobei das Stapeln im Schritt (d) so ausgeführt wird, dass jeder von N Stapeln in der Entladeeinheit nur Streifen eines einzelnen Herstellungsloses aufweist, die die Verarbeitung erfolgreich durchlaufen haben, und N Stapel in der Entladeeinheit nur Streifen eines einzelnen Herstellungsloses aufweisen, deren Verarbeitung fehlgeschlagen hat, wobei insbesondere jeder der 2N Stapel in der Entladeeinheit nur Streifen eines anderen jeweiligen Herstellungsloses aufweist.

7. Verfahren nach Anspruch 1, wobei die in den Fächern der Ladeeinheit platzierten Stapel Streifen aus unterschiedlichen Herstellungslosen aufweisen.

8. Verfahren nach einem der Ansprüche 1 bis 7, wobei die Streifen in einem speziellen Fach der Fächer der Entladeeinheit auf der Grundlage der ausgelesenen Information gestapelt werden.

9. Verfahren nach einem der Ansprüche 1 bis 8, wobei N = M oder M = 1 gilt.

10. Bauteilstreifen-Handhabungseinheit, insbesondere Prüfung-im-Streifen-Handhabungseinheit, zur Ausführung eines Verfahrens gemäß einem der Ansprüche 1 bis 9, mit:
einer Ladeeinheit;
einer Verarbeitungseinheit; und
einer Entladeeinheit;
wobei die Ladeeinheit eine erste Anzahl N1 ≥ 2 an Fächern aufweist und jedes Fach der Ladeeinheit ausgebildet ist, einen Stapel aus Streifen aufzunehmen, wobei die Entladeeinheit eine zweite Anzahl N2 ≥ (N1 +1) aus Fächern aufweist und wobei jedes Fach der Entladeeinheit ausgebildet ist, einen Stapel aus Streifen aufzunehmen;
wobei die Bauteilstreifen-Handhabungseinheit ferner eine Kennung-Leseeinheit zum Auslesen einer Kennung eines Streifens aufweist.

11. Bauteilstreifen-Handhabungseinheit nach Anspruch 10, wobei N2 = (N1 +1), N2 = (N1 +2) oder N2 = 2·N1 gilt.

12. Bauteilstreifen-Handhabungseinheit nach Anspruch 10 oder 11, die ferner eine oder mehrere weitere Ladeeinheiten und/oder eine oder mehrere weitere Entladeeinheiten aufweist.

13. Bauteilstreifen-Handhabungseinheit nach einem der Ansprüche 10 bis 12, wobei die Ladeeinheit K Untereinheiten und die Entladeeinheit L der Untereinheiten aufweist, und wobei L ≥ 2 für K = 1 und L ≥ K für K >1 gilt.

## Revendications

1. Procédé de fonctionnement d'un manipulateur de bandes, en particulier d'un manipulateur d'essai en bande comportant une unité de chargement, une unité de traitement, en particulier une unité d'essai ou une unité de marquage, et une unité de déchargement, l'unité de chargement comprenant un premier nombre N1 de compartiments et chaque compartiment de l'unité de chargement étant configuré pour recevoir une pile de bandes, l'unité de déchargement comprenant un deuxième nombre N2 de compartiments et chaque compartiment de l'unité de déchargement étant configuré pour recevoir une pile de bandes, le procédé comprenant les étapes suivantes :
(a) positionnement d'un nombre N de piles de bandes dans N compartiments respectifs de l'unité de chargement ;
(b) chargement d'une bande depuis l'unité de chargement vers l'unité de traitement pour traiter la bande ;
(c) déchargement de la bande depuis l'unité de traitement ; et
(d) empilement de la bande dans un compartiment parmi un nombre N+M de compartiments de l'unité de déchargement ;
dans lequel N ≥ 2, M ≥ 1, N ≤ N1 et (N + M) ≤ N2 ;
dans lequel chaque bande comporte un identifiant de bande qui comprend de l'information pour identifier la bande particulière, en particulier de l'information pour identifier un lot de production pour cette bande, l'identifiant de bande étant lu par un lecteur d'identifiant du manipulateur de bandes.

2. Procédé selon la revendication 1, comprenant en outre la répétition des étapes (b) à (d), en particulier la répétition des étapes (b) à (d) jusqu'à ce que l'unité de chargement soit vide, et ensuite la répétition de l'étape (a).

3. Procédé selon la revendication 1 ou 2, dans lequel chaque pile desdites N piles dans l'unité de chargement comprend uniquement des bandes d'un lot de production, en particulier dans lequel chaque pile comprend des bandes d'un lot de production respectif différent ou dans lequel toutes les piles desdites N piles comprennent des bandes du même lot de production.

4. Procédé selon l'une des revendications 1 à 3, dans lequel M = 1 et chaque pile parmi N piles dans l'unité de déchargement comprend uniquement des bandes d'un lot de production dont le traitement a réussi et une pile dans l'unité de déchargement comprend uniquement des bandes dont le traitement a échoué, et en particulier dans lequel chaque pile desdites N piles dans l'unité de déchargement comprend uniquement des bandes d'un lot de production respectif différent.

5. Procédé selon l'une des revendications 1 à 3, dans lequel M = 2 et chaque pile parmi N piles dans l'unité de déchargement comprend uniquement des bandes d'un lot de production dont le traitement a réussi et une pile dans l'unité de déchargement comprend uniquement des bandes dont le traitement a échoué du fait d'un dysfonctionnement de la bande traitée, et une autre pile dans l'unité de déchargement comprend uniquement des bandes dont le traitement a échoué du fait d'un dysfonctionnement de l'unité de traitement, et de préférence dans lequel chaque pile desdites N piles dans l'unité de déchargement comprend uniquement des bandes d'un lot de production respectif différent.

6. Procédé selon l'une des revendications 1 à 3, dans lequel M = N et l'empilement à l'étape (d) est mis en oeuvre de telle sorte que chaque pile parmi N piles dans l'unité de déchargement comprend uniquement des bandes d'un lot de production dont le traitement a réussi et chaque pile parmi N piles dans l'unité de déchargement comprend uniquement des bandes d'un lot de production dont le traitement a échoué, et en particulier dans lequel chaque pile desdites 2N piles dans l'unité de déchargement comprend uniquement des bandes d'un lot de production respectif différent.

7. Procédé selon la revendication 1, dans lequel les piles placées dans les compartiments de l'unité de chargement comprennent des bandes provenant de différents lots de production.

8. Procédé selon l'une quelconque des revendications 1 à 7, dans lequel les bandes sont empilées dans un compartiment particulier des compartiments de l'unité de déchargement sur base de l'information lue.

9. Procédé selon l'une des revendications 1 à 8, dans lequel N = M ou M = 1.

10. Manipulateur de bandes, et en particulier manipulateur d'essai en bande, pour mettre en oeuvre un procédé selon l'une des revendications 1 à 9, comprenant :
une unité de chargement ;
une unité de traitement ; et
une unité de déchargement ;
dans lequel l'unité de chargement comprend un premier nombre N1 ≥ 2 de compartiments et chaque compartiment de l'unité de chargement est configuré pour recevoir une pile de bandes, l'unité de déchargement comprenant un deuxième nombre N2 ≥ (N1 + 1) de compartiments et chaque compartiment de l'unité de déchargement est configuré pour recevoir une pile de bandes ;
le manipulateur de bandes comprenant en outre un lecteur d'identifiant pour lire un identifiant de bande.

11. Manipulateur de bandes selon la revendication 10, dans lequel N2 = (N1 + 1), N2 = (N1 + 2) ou N2 = 2·N1.

12. Manipulateur de bandes selon la revendication 10 ou 11, comprenant en outre une ou plusieurs unités de chargement additionnelles et/ou une ou plusieurs unités de déchargement additionnelles.

13. Manipulateur de bandes selon l'une des revendications 10 à 12, dans lequel l'unité de chargement comprend K sous-unités et l'unité de déchargement comprend L desdites sous-unités, et dans lequel L ≥ 2 pour K = 1 et L ≥ K pour K > 1.
